# EUROPÄISCHE PATENTSCHRIFT

(11) **EP 1 010 987 B1**
(45) Veröffentlichungstag und Bekanntmachung des Hinweises auf die Patenterteilung: **29.08.2007**
(21) Anmeldenummer: 99124718.0
(22) Anmeldetag: 11.12.1999
(51) Int. Cl.: G01R 33/07

(54) **Hallsensor**
Hall sensor
Capteur à effet Hall

(30) Priorität: 19.12.1998 DE 19858868
(43) Veröffentlichungstag der Anmeldung: 21.06.2000
(73) Patentinhaber: Micronas GmbH, 79108 Freiburg i. Br. (DE)
(72) Erfinder: Motz, Mario, 9524 St. Magdalen (Villach) (AT)
(74) Vertreter: Goy, Wolfgang

(56) Entgegenhaltungen:
- EP-A- 0 450 910
- EP-A- 0 548 391
- DE-A- 4 302 342
- US-A- 5 260 614
- US-A- 5 604 433
- US-A- 5 747 995

## Beschreibung

Die Erfindung betrifft einen Hallsensor nach dem Oberbegriff des Anspruchs 1.

Hallsensoren dienen zur Messung von magnetischen Feldern. Der Hallsensor ist insbesondere als monolithisch integriertes Bauelement ausgeführt, welches den Hallsensor, die Stromversorgung und die elektronischen Auswerteschaltungen für die Hallspannung enthält. Für die Herstellung dieser kombinierten Schaltung wird in der Regel eine der üblichen Silizium-Halbleitertechnologien verwendet, die den geläufigen Bipolar- oder MOS-Herstellungsprozessen entsprechen.

Ein bekannter Nachteil von Silizium als Hall-Detektormaterial ist der große Einfluß von mechanischen Belastungen (dem sogenannten Streß), nämlich der Piezoeffekt und/oder piezoresistiver Effekte (bleibende Widerstandsänderung bei Verformung). Diese führen zu Offsetspannungsfehlern, welche von den mechanischen Spannungen im Kristallgefüge und der richtungsabhängigen Hallempfindlichkeit bewirkt sind. Aus diesem Grunde sind offsetkompensierte Hallsensoren, insbesondere Hallsensoren mit Orthogonalumschaltung bekannt.

Ein Hallsensor der eingangs genannten Art ist durch die EP-A-0 548 391 bekannt. Die Grundidee besteht dabei darin, eine rotationssymmetrische, beispielsweise quadratische Hall-Platte elektrisch um 90° hin und her zu schalten und die erhaltenen Meßwerte zu addieren oder zu subtrahieren. Für die Betrachtung der Offsetfehler kann die Hall-Platte dabei näherungsweise als eine Brückenschaltung betrachtet werden. Bei idealer Gültigkeit der Brückenersatzschaltung tritt bei dieser Orthogonalumschaltung der Offsetfehler jeweils mit einem anderen Vorzeichen auf, so daß sich bei der Überlagerung der beiden orthogonalen Hallspannungen der Offsetfehler auf diese Weise nahezu vollständig kompensiert. Beide Orthogonalmessungen erfolgen somit über dieselbe identische Struktur mit einem einzigen Streßprofil. Auf diese Weise kann der Streß - wie ausgeführt - kompensiert werden.

Der mechanische Streß, welcher auf einen Hallsensor mit der Folge einer unerwünschten Piezospannung wirkt, führt somit zu Offset-Problemen. Derartiger mechanischer Streß kann beispielsweise nach dem Vergießen des Hallsensors in einem Modul auftreten. Auch eine Druckausübung auf die Hallplatten oder die Schaltung führt zu einem internen mechanischen Streß. Teilweise ist es aber wichtig, die Größe dieses Stresses zu kennen. Das Problem besteht aber darin, daß der genaue Wert des Stresses bei unterschiedlichen Hallsensoren nicht reproduzierbar ist und daher bei jedem Hallsensor individuell gemessen werden muß, um so den Streß nach dem Vergießen des Hallsensors bewerten, nämlich messen oder gar bei der Anwendung eine entsprechende Kompensation vornehmen zu können.

Außerdem ist es teilweise wichtig, außer der Größe des Stresses auch die Temperatur des Hallsensors zu kennen, um auch hier eine Kompensation von Fehlern vornehmen zu können.

Durch die DE 43 02 342 A, die EP-A-0 450 910 und die US-A-5 260 614 sind ebenfalls Hallsensoren bekannt, bei welchen temperaturbedingte und stressbedingte störende Offsetspannungen durch Kompensationsschaltungen vermindert oder kompensiert werden können.

Der Erfindung liegt die **Aufgabe** zugrunde, bei einem Hallsensor der eingangs genannten Art außer der herkömmlichen Magnetfeld-Messung mittels des Hallsensors auch eine Messung des im Hallsensor herrschenden Stresses und/oder der Temperatur durchführen zu können.

Zur **Lösung** der Aufgabe ist der Hallsensor gemäß dem Oberbegriff des Anspruchs 1 entsprechend dem kennzeichnenden Teil dieses Anspruchs ausgebildet.

Dadurch ist ein Hallsensor mit integrierter Streß-Messung geschaffen. Die Grundidee der Erfindung besteht darin, alternativ zur - herkömmlichen - Messung des Magnetfeldes mittels des Hallsensors durch eine entsprechende Umschaltung der Hall-Plattenanschlüsse den Streß messen zu können, wobei bei dieser Streß-Messung das gegebenenfalls vorhandene Magnetfeld kompensiert und daher nicht mitgemessen wird. Dabei tritt bei der Orthogonalumschaltung der Offsetfehler jeweils mit gleichem Vorzeichen auf, so daß sich bei der Überlagerung der beiden orthogonalen Hallspannungen der Offsetfehler in der nachfolgenden Signalverarbeitungseinheit nicht - wie bei der Magnetfeld-Messung - kompensiert. Allerdings kompensieren sich die Magnetfeldanteile der orthogonalen Hallspannungen, da sie mit unterschiedlichen Vorzeichen auftreten. Der so gemessene Streß im Hallsensor kann für Untersuchungen und Tests des Gesamtsystems verwendet werden, außerdem kann das Streßsignal zur Kompensation von Fehlern verwendet werden. Technisch läßt sich dies dergestalt realisieren, daß der Hallsensor in der Lage ist, aufgrund eines externen Steuersignals seine Meßwertausgabe umzuschalten. Dabei kann mit vorhandenen Schaltungsmitteln von der Ausgabe des Magnetfeldes auf die Ausgabe des internen mechanischen Stresses umgeschaltet werden. Somit wird der Streß der Hallplatte ermittelt. Die Ausführung erlaubt somit eine getrennte Messung des Magnetfeldes und des Stresses.

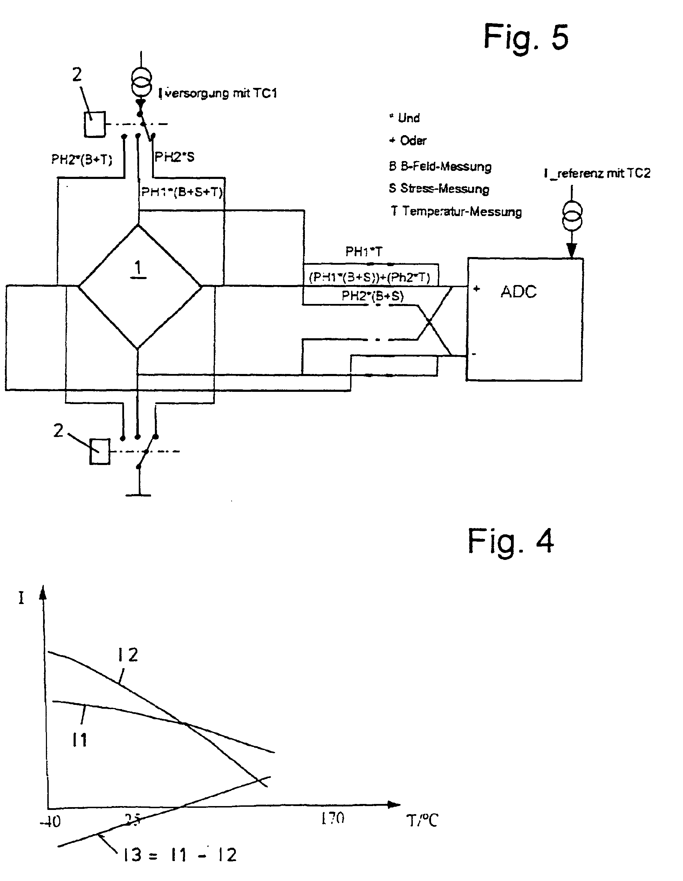

Weiterhin besteht die Grundidee darin, außer der - herkömmlichen - Magnetfeld-Messung eine Temperatur-Messung durchzuführen, ohne daß gleichzeitig eine Magnetfeld-Messung durchgeführt wird. Die digitale Temperatur-Messung mit gleichzeitiger Ausschaltung der Magnetfeld-Messung verwendet dabei einen oder zwei vorhandene Ströme der Hallsensor-Schaltungsanordnung und wertet diese hinsichtlich ihres Verhaltens mit vorgegebenen unterschiedlichen Temperaturkoeffizienten aus. Als Beispiel für die Erzeugung von temperaturabhängigen Strömen in Verbindung mit monolithisch integrierten Hallsensoren wird auf EP 0 525 235 verwiesen. Bei der Verwendung eines einzigen Stromes kann somit ein Strom mit einem vorgegebenen Temperaturkoeffizienten verwendet werden. Diesem einen Strom kann ein zweiter Strom mit anderem Temperaturkoeffizienten zugeschaltet werden. Durch gewichtete Addition oder Subtraktion der beiden Ströme mit ihren unterschiedlichen Temperaturkoeffizienten können unterschiedliche, temperaturabhängige Ströme erzeugt werden, nämlich Ströme mit anderen Temperaturkoeffizienten oder Ströme, welche so ausgebildet sind, daß sie bei einer Bezugstemperatur das Vorzeichen wechseln (vgl. Fig. 4). Eine Orthogonalumschaltung ist während der Temperatur-Messung nicht notwendig, da auf Schaltungsströme innerhalb der Hallsensorschaltung zurückgegriffen wird und nicht auf Hallspannungen. Die Stromeinspeisungspunkte und Spannungsabgriffe an der Hallplatte sind bei der Temperaturmessung identisch. Die Eingänge der nachfolgenden Signalverarbeitung können wechselseitig getauscht werden. Wie schon bei der Streß-Messung ist der Hallsensor in der Lage, aufgrund eines externen Signals seine Ausgabe auf Temperatur-Messung-umzu-schalten. Dabei kann mit den in der Schaltung vorhandenen Schaltungsmitteln von der Ausgabe des Magnetfeldes auf die Ausgabe der Temperatur umgeschaltet werden. Dies läßt sich durch eine geringfügige Modifikation der Gesamtschaltung realisieren. Die Temperatur-Messung im Hallsensor kann für Untersuchungen und Tests des Gesamtsystems verwendet werden. Außerdem kann das Temperatursignal zur Kompensation von Fehlern verwendet werden.

Eine technische Realisierung der Magnetfeld-Messung gemäß Anspruch 2 sieht vor, daß für die Streß-Messung zwar gleichermaßen eine Orthogonalumschaltung jedoch mit einer gegenüber der Magnetfeld-Messung entgegengesetzten 90°-Drehung des Hallplatten-Versorgungsstromes für die beiden Halbphasen durchgeführt wird, wobei in der zweiten Halbphase die Abgriffe für die Hallspannung unverändert bleibt (so daß sich die Bezugsrichtung für die Hallspannung am Eingang des Differenzverstärkers nicht ändert), daß aber die Richtung des angelegten Versorgungsstromes für den Hallsensor im Vergleich zur Magnetfeld-Messung entgegengesetzt ist. Die Stromflußrichtung durch die Hallplatte ist somit bei der Streß-Messung gerade umgekehrt zu der Stromflußrichtung bei der Magnetfeld-Messung. Die - bereits beschriebene - Konsequenz davon ist, daß der Offset nicht - wie bei der Magnetfeld-Messung - kompensiert wird, sondern daß der Offset als Folge des Stresses als Resultierende übrigbleibt, und zwar unabhängig vom Magnetfeld, welches sich aufgrund der beiden Orthogonalmeßwerte kompensiert.

Die Verwendung eines einzigen Stromes oder zweier Ströme schlagen die Weiterbildungen der Ansprüche 3 und 4 vor.

Die Weiterbildung der Temperatur-Messung mit den Merkmalen des Anspruchs 5 hat den Vorteil der technisch einfachen Realisierung, wobei der Differenzstrom über Schalter und einen Widerstand an die vorhandene, nachgeordnete Signalverarbeitungseinheit, beispielsweise einen Analog-Digital-Konverter (= ADC) geschaltet werden kann. Das Grundprinzip besteht darin, daß ein vorhandener Strom in einen Stromverteilungsknoten eingespeist und ein Teilstrom geringerer Größe abgeführt wird. Da der abfließende Strom kleiner ist als der zufließende Strom, fällt an einem Widerstand des Stromsystems eine zu dem temperaturabhängigen Differenzstrom proportionale Spannung ab, welche ein Maß für die Temperatur des Hallsensors ist.

Eine Weiterbildung schlagen die Merkmale des Anspruchs 6 vor. Dadurch läßt sich ein optimales Temperaturverhalten und damit eine genaue Temperatur-Messung erzielen.

Eine weitere Weiterbildung schlagen die Merkmale des Anspruchs 7 vor. Die Grundidee besteht darin, daß die Basis-Emitter-Spannung eines Bipolartransistors mit der Temperatur abnimmt, was hauptsächlich durch eine im Emitter gegenüber der Basis verringerte Energielücke bedingt ist. Dieser als "Bandgap" bezeichnete Effekt ist eine Folge der hohen Dotierung im Emitter und kann für die Temperaturmessung im Hallsensor verwendet werden.

Die Weiterbildung in Anspruch 8 schlägt vor, daß die Hallplatte zugleich auch als Widerstand für die Temperaturmessung verwendet wird. Selbstverständlich könnte auch ein anderer, separater Widerstand verwendet werden.

Dadurch ist ein Hallsensor mit einer entsprechenden Schaltung geschaffen, mit der eine - herkömmliche - Magnetfeld-Messung, wahlweise aber auch eine Streß-Messung oder eine Temperatur-Messung (jeweils ohne die Magnetfeld-Messung) möglich ist. Die erfinderische Gesamtidee, in einer gemeinsamen Gesamtschaltung eine Magnetfeld-Messung, eine Streß-Messung oder eine Temperatur-Messung alternativ durchführen zu können, läßt sich mit den bereits vorhandenen Komponenten der - herkömmlichen - Magnetfeld-Messung mit geringfügigen Modifikationen in der Gesamtschaltung durchführen. Dadurch kann mit vorhandenen Schaltungsmitteln auf die jeweils gewünschte Meßalternative umgeschaltet werden, um so auf technisch einfache Weise durch die Streß- oder Temperatur-Messung im Hallsensor Untersuchungen und Tests des Gesamtsystems vornehmen zu können, außerdem um das Streß- oder Temperatursignal zur Kompensation von Fehlern verwenden zu können.

Eine einfache technische Realisierung schlagen die Merkmale der Ansprüche 9 und 10 vor.

Eine bevorzugte Durchführung für das Messen der Hallspannung schlagen die Merkmale des Anspruchs 11 vor, wobei Weiterbildungen für die technische Realisierung durch die Merkmale der Ansprüche 12 bis 14 gegeben sind. Bei der Verwendung eines Delta-Sigma-Wandlers höherer Ordnung (Anspruch 12) werden mehrere Integrationsschleifen verwendet. Der erste Transkonduktanzverstärker (OTA = Operational Transconductance Amplifier) wandelt die Hallspannung in einen Strom um. Der zweite Transkonduktanzverstärker (oder OPV = Operational Amplifier) integriert diesen Strom beispielsweise mittels eines Kondensators. Die resultierende Spannung am Kondensator wird mittels eines Analog-Digital-Wandlers (=ADC) digitalisiert. Das digitale Signal wird verarbeitet (unter Umständen beispielsweise teilweise integriert) und über einen Digital-Analog-Wandler (=DAC) in ein Gegenkopplungssignal gewandelt und an den Spannungsabgriffspunkten als Kompensationsstrom in die Hallplatte eingespeist und erzeugt dort über den Innenwiderstand der Hall-platte eine Gegenkopplungsspannung. Das ganze System schwingt am Eingang des ersten OTA's im zeitlichen Mittel auf 0 V ein. Damit kompensiert die Gegenkopplungsspannung die Hallspannung, und das digitale DAC-Eingangssignal ist ein Maß für die Hallspannung (Delta-Sigma-Wandler-Prinzip). Somit wird durch die Rückführung des Signals mittels der damit verbundenen Rückkopplung das System auf "Null" gesetzt.

Schließlich schlägt noch eine Weiterbildung vor, daß die Aufgabe der Hallspannung an die weitere Signalverarbeitung getaktet erfolgt. Dadurch wird die Offset-Problematik in der nachfolgenden Signalverarbeitungseinheit, beispielsweise in einem ADC, kompensiert. Beispielsweise werden die beiden Eingänge des Eingangsdifferenzverstärkers vertauscht. Dabei können die Orthogonalumschaltung und das Takten gleichzeitig durchgeführt werden.

Ausführungsbeispiele eines erfindungsgemäßen Hallsensors zur wahlweisen Magnetfeld-, Streß- sowie Temperatur-Messung werden nachfolgend anhand der Zeichnungen beschrieben. In diesen zeigt:
- Fig. 1a und b: das Prinzipschaltbild der Magnetfeld-Messung;
- Fig. 2a und b: das Prinzipschaltbild der Streß-Messung;
- Fig. 3a und b: das Prinzipschaltbild der Temperatur-Messung;
- Fig. 4: ein Schaubild mit den unterschiedlichen Temperaturkoeffizienten bei der Temperatur-Messung in Fig. 3a und b;
- Fig. 5: ein gemeinsames Prinzipschaltbild für die Magnetfeld-, Streßsowie Temperatur-Messung der Fig. 1a und b bis Fig. 3a und b;
- Fig. 6a und b: ein Schaltungsschaltbild für die Magnetfeld-Messung basierend auf Fig. 1a und b;
- Fig. 7a und b: ein Schaltungsschaltbild für die Streß-Messung basierend auf Fig. 2a und b;
- Fig. 8a und b: ein Schaltungsschaltbild für die Temperatur-Messung basierend auf Fig. 3a und b.

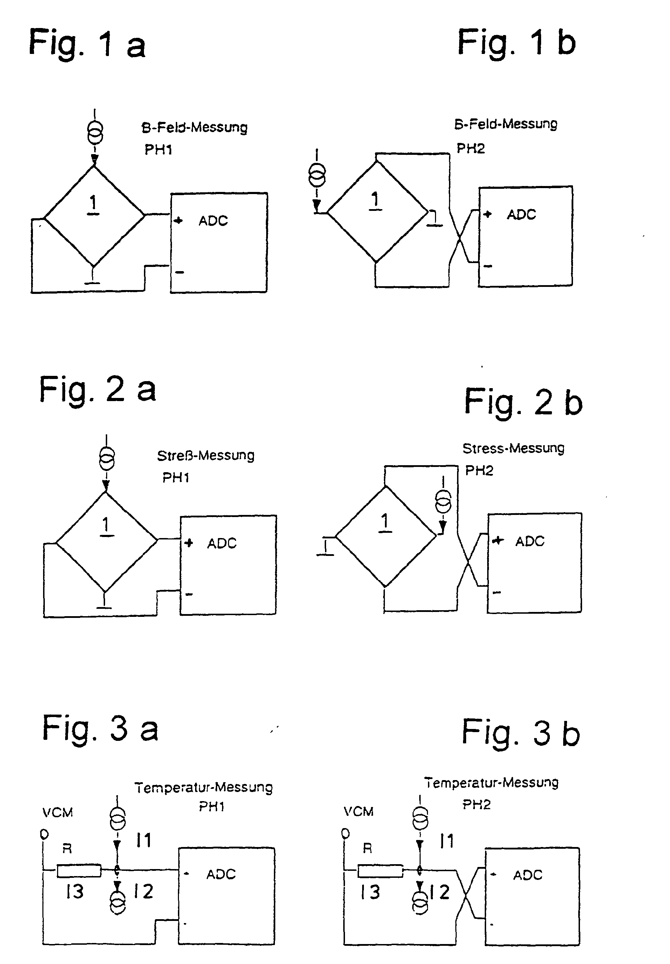

Fig. 1a und b zeigt die - herkömmliche - Magnetfeld-Messung eines Hallsensors mit Orthogonalumschaltung. Eine quadratische Hallplatte 1 weist dabei vier Anschlüsse auf, nämlich zwei Anschlüsse für den Hallsensor-Versorgungsstrom sowie zwei Anschlüsse für die Hallspannungsabgriffe. Diese Hallspannungsabgriffe werden einem Analog-Digital-Konverter ADC zugeführt. Die Hallplatte 1 ist beispielsweise durch eine Widerstandsstruktur (=Rwell) gebildet, die in CMOS-Technik mittels einer Wannenstruktur realisiert ist.

Die Funktionsweise für die Magnetfeld-Messung ist wie folgt:

Durch eine Orthogonalumschaltung (vgl. Fig. 1b gegenüber Fig. 1a) werden die Anschlüsse für den Hallsensor-Versorgungsstrom sowie für die Hallspannungsabgriffe durch eine entsprechende (in den Zeichnungen jedoch nicht dargestellte) Schaltersteuerung (im Gegenuhrzeigersinn) vertauscht. Gleichzeitig werden die Anschlüsse der Hallspannungsabgriffe am Analog-Digital-Konverter ADC ebenfalls durch "Choppen" vertauscht. Die Wirkung der Orthogonalumschaltung ist, daß die Offsetfehler in den beiden orthogonalen Hallspannungen infolge Streß mit einem anderen Vorzeichen auftreten und sich bei der Summierung in einer dem Analog-Digital-Konverter ADC nachfolgenden Summiereinheit kompensieren.

Die Streß-Messung der Fig. 2a und b basiert auf dem gleichen Grundprinzip wie die Magnetfeld-Messung der Fig. 1a und b, jedoch mit dem Unterschied, daß die Einspeisung des Hallsensor-Versorgungsstromes in der zweiten Halbphase PH2 entgegengesetzt gerichtet zur Stromeinspeisung der Magnetfeld-Messung ist. Die Konsequenz ist, daß sich bei der Summierung der beiden orthogonalen Hallspannungen die Anteile für das Magnetfeld kompensieren, während sich die streßbedingten Offsetfehler nicht kompensieren und daher als Signal gemessen und weiterverarbeitet werden. Dadurch kann die streßbedingte Spannung gemessen und für Untersuchungen und Tests des Gesamtsystems sowie zur Kompensation von Fehlern verwendet werden.

Die Temperatur-Messung der Fig. 3a und b verwendet Ströme, welche in der Schaltungsanordnung des Hallsensors - ohnehin - vorhanden sind. Es handelt sich dabei um Ströme mit unterschiedlichen Temperaturkoeffizienten. An dem Analog-Digital-Konverter ADC liegt die Spannung VCM an, welche für beide ADC-Eingänge gleich ist. Der Strom 13 hat beispielsweise einen positiven Temperaturkoeffizienten, wie er im Schaubild in Fig. 4 aufgezeichnet ist. Dieser Strom 13 resultiert aus zwei Teilströme I1 und 12. Der erste, schwach negative Teilstrom I1 basiert auf dem Bandgap-Effekt eines Bipolartransistors. Der zweite Teilstrom 12 hat beispielsweise ein stark negatives Temperaturverhalten, wie dies im Schaubild in Fig. 4 erkennbar ist. Der resultierende Strom I3 entspricht dem - ebenfalls in Fig. 4 eingezeichneten - Differenzstrom aus dem Teilstrom I1 und dem Teilstrom I2. Dieser Differenzstrom erzeugt am Widerstand R einen Spannungsabfall, der vom Analog-Digital-Konverter ADC gemessen wird. Durch die temperaturabhängig unterschiedlichen Ströme 11 und 12 wird somit am Widerstand R eine ebenfalls temperaturabhängige Spannung gebildet. Zur Bestimmung der Temperatur wird diese Spannung mit einer Vergleichsspannung, z.B. aus einer Bandgap-Schaltung, verglichen. In gleicher Weise kann die Temperatur durch Vergleich des resultierenden Stromes I3 mit einem Referenzstrom gebildet werden, der z.B. in der Bandgap-Schaltung erzeugt wird.

Dies bedeutet, daß mittels der in der Hallsensor-Schaltung vorhandenen Ströme mit unterschiedlichen Temperaturkoeffizienten die im Hallsensor herrschende Temperatur gemessen werden kann.

Fig. 5 zeigt die Vereinigung der Einzelschaltbilder der Fig. 1a und b, Fig. 2a und b sowie Fig. 3a und b in einer prinzipiellen Gesamtschaltung. Durch eine entsprechende Steuerung von Schaltern 2 können die drei verschiedenen Messungen (Magnetfeld, Streß, Temperatur) mit den Orthogonalumschaltungen durchgeführt werden.

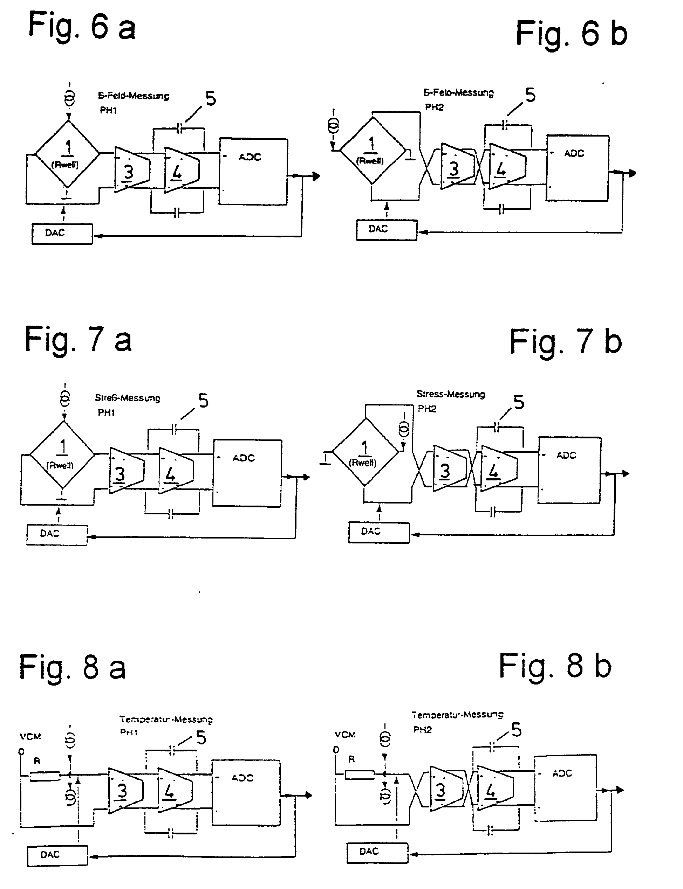

Fig. 6a und b zeigt ausgehend vom Prinzipschaltbild in den Fig. 1a und b das technische Realisierungsschaltbild für die Magnetfeld-Messung. Ein erster Verstärker 3, beispielsweise ein Operational Transconductance Amplifier (= OTA), wandelt die Hallspannung in einen Differenzstrom um. Ein nachfolgender zweiter Verstärker 4, beispielsweise ebenfalls ein OTA oder ein Operationsverstärker, integriert dieses Differenzstrompaar über parallel geschaltete Kondensatoren 5. Die resultierenden Spannungen an den Kondensatoren werden in einem Analog-Digital-Konverter ADC digitalisiert und als digitaler Hallspannungs-Meßwert abgegeben. Das so erzeugte digitale Signal kann dann über einen Digital-Analog-Wandler DAC in ein Gegenkopplungssignal gewandelt werden. Im Ausführungsbeispiel wird durch den DAC-Strom über den Innenwiderstand der Hallplatte 1 das Gegenkopplungssignal in eine Gegenkopplungsspannung gewandelt, wodurch das Hallspannungs-Meßsystem am Eingang des ersten Verstärkers 3 im zeitlichen Mittel auf 0 V gezogen wird. Damit kompensiert die Gegenkopplungsspannung die Hallspannung, und das digitale ADC-Ausgangssignal ist ein Maß für die Hallspannung (Delta-Sigma-Wandler-Prinzip).

Die Streß-Messung der Fig. 7a und b sowie die Temperatur-Messung der Fig. 8a und b erfolgt analog.

### Bezugszeichenliste

- 1: Hallplatte
- 2: Schalter
- 3: Verstärker
- 4: Verstärker
- 5: Kondensator

## Patentansprüche

1. Hallsensor
mit einer Einrichtung zur Orthogonalumschaltung des Hallsensor-Versorgungsstromes sowie der Hallspannungsabgriffe,
wobei die Geometrie der Hallplatte (1) in den Orthogonalpositionen für die Hallspannungsbestimmung gleich ist,
sowie mit einer Summiereinrichtung, der die Hallspannungswerte der Orthogonalpositionen zur Bildung eines offsetkompensierten Hallspannungswertes zugeführt sind,
**dadurch gekennzeichnet,**
**daß** zu einer Streß-Messung die Hallspannungswerte der Orthogonalpositionen derart der Summiereinrichtung zugeführt und/oder in der Summiereinrichtung verarbeitet sind,
**daß** die durch das Magnetfeld bedingten Anteile der Hallspannungswerte kompensiert und nur die durch den Offset bedingten Anteile der Hallspannungswerte gemessen sind und/oder
**daß** zu einer Temperatur-Messung mindestens ein in der Schaltung des Hallsensors vorhandener Strom (11, 12, 13) mit einem vorgegebenen Temperaturkoeffizienten verwendet ist, dessen Spannungsabfall an einem Widerstand (R; Rwell) zur Temperatur-messung verwendet ist.

2. Hallsensor nach Anspruch 1,
**dadurch gekennzeichnet,**
**daß** bei der Orthogonalumschaltung der Hallsensor-Versorgungsstrom im Vergleich zu der Orthogonalumschaltung zur Bildung des offsetkompensierten Hallspannungswertes zur Streß-Messung um 180° vertauscht ist,
während die Orthogonalumschaltung der Hallspannungsabgriffe im Vergleich zu der Orthogonalumschaltung zur Bildung des offsetkompensierten Hallspannungswertes unverändert ist.

3. Hallsensor nach einem der vorhergehenden Ansprüche,
**dadurch gekennzeichnet,**
**daß** ein einziger in der Schaltung des Hallsensors vorhandener Strom mit vorgegebenem Temperaturkoeffizienten verwendet ist.

4. Hallsensor nach einem der vorhergehenden Ansprüche,
**dadurch gekennzeichnet,**
**daß** zwei in der Schaltung des Hallsensors vorhandene Ströme (11, 12) mit relativ zueinander unterschiedlichen Temperaturkoeffizienten addiert oder subtrahiert sind.

5. Hallsensor nach Anspruch 4,
**dadurch gekennzeichnet,**
**daß** ein Strom (I1) auf einen Stromverzweigungspunkt geschaltet ist und ein dabei entstehender Teilstrom (I3) über einen Widerstand (R; Rwell) geführt ist und der dabei entstehende Spannungsabfall für die weitere Signalverarbeitung verwendet ist.

6. Hallsensor nach Anspruch 5,
**dadurch gekennzeichnet,**
**daß** der zugeführte Strom (I1) einen ersten Temperaturkoeffizienten und der entstehende Teilstrom (13) einen zweiten Temperaturkoeffizienten aufweist.

7. Hallsensor nach einem der vorhergehenden Ansprüche,
**dadurch gekennzeichnet,**
**daß** zur Bildung mindestens eines Stromes (11, 12, I3) eine Bandgap-Schaltung mit Bipolartransistoren verwendet ist.

8. Hallsensor nach einem der vorhergehenden Ansprüche,
**dadurch gekennzeichnet,**
**daß** für die Temperaturmessung die Hallplatte (1) als Widerstand (Rwell) verwendet ist.

9. Hallsensor nach einem der vorhergehenden Ansprüche,
**dadurch gekennzeichnet,**
**daß** eine für die Magnetfeld-Messung, die Streß-Messung und die Temperatur-Messung gemeinsame Schaltstufe mit Schaltern (2) zum wahlweisen Ansteuern der drei Meßoptionen vorgesehen ist.

10. Hallsensor nach Anspruch 9,
**dadurch gekennzeichnet,**
**daß** zur Signalverarbeitung die Signale mittels eines Analog-Digital-Wandlers (ADC) digitalisiert sind.

11. Hallsensor nach einem der vorhergehenden Ansprüche,
**gekennzeichnet durch**
eine Einrichtung zum Kompensieren der Hallspannung und/oder Streßspannung und/oder Temperaturspannung mittels einer Gegenkopplungsspannung.

12. Hallsensor nach Anspruch 11,
**dadurch gekennzeichnet,**
**daß** die Digitalisierung der Signale mittels eines Delta-Sigma-Wandler erster oder höherer Ordnung erfolgt.

13. Hallsensor nach Anspruch 11 oder 12,
**dadurch gekennzeichnet,**
**daß** ein erster Verstärker (3) vorgesehen ist, welcher die Hallspannung in einen Strom, insbesondere in ein Differenzstrompaar umwandelt,
**daß** in einer nachgeschalteten Stufe, die einen zweiten Verstärker (4) mit einem Integrator enthält, dieser Strom integriert und als Spannungssignal weiterverarbeitet ist,
und **daß** eine Einrichtung vorgesehen ist, welche dieses Spannungssignal in ein Gegenkopplungssignal wandelt.

14. Hallsensor nach Anspruch 13,
**dadurch gekennzeichnet,**
**daß** die analoge Spannung des zweiten Verstärkers (4) zur Bildung des Gegenkopplungssignals digitalisiert ist.

## Claims

1. Hall sensor
with a device for orthogonal switching of the Hall sensor supply current and the Hall voltage take-off,
wherein the geometry of the Hall plate (1) is the same in the orthogonal positions for determination of Hall voltage,
and with a summing device to which the Hall voltage values of the orthogonal positions are supplied to form an offset-compensated Hall voltage value,
**characterised in that**
for stress measurement, the Hall voltage values of the orthogonal positions are supplied to and/or processed in the summing device such that the proportions of the Hall voltage values caused by the magnetic field are compensated and only the proportions of the Hall voltage values caused by the offset are measured, and/or
for temperature measurement, at least one current (11, 12, 13) present in the circuit of the Hall sensor with a preset temperature coefficient is used, the voltage drop of which is used at a resistor (R; Rwell) for temperature measurement.

2. Hall sensor according to claim 1, **characterised in that** for stress measurement, in the orthogonal switching the Hall sensor supply current is turned through 180° in comparison with the orthogonal switching to form the offset-compensated Hall voltage value, while the orthogonal switching of the Hall voltage take-offs remains unchanged in comparison with the orthogonal switching to form the offset-compensated Hall voltage value.

3. Hall sensor according to one of the preceding claims, **characterised in that** a single current present in the Hall sensor circuit with preset temperature coefficient is used.

4. Hall sensor according to any of the preceding claims, **characterised in that** two currents (11, 12) present in the circuit of the Hall sensor, with different temperature coefficients in relation to each other, are added or subtracted.

5. Hall sensor according to claim 4, **characterised in that** one current (11) is connected to a current branch point and the resulting part current (13) is passed over a resistor (R; Rwell) and the resulting voltage drop used for further signal processing.

6. Hall sensor according to claim 5, **characterised in that** the supplied current (I1) has a first temperature coefficient and the resulting part current (13) a second temperature coefficient.

7. Hall sensor according to any of the preceding claims, **characterised in that** to form at least one current (11, 12, 13), a band gap circuit with bipolar transistors is used.

8. Hall sensor according to any of the preceding claims, **characterised in that** for temperature measurement, the Hall plate (1) is used as a resistor (Rwell).

9. Hall sensor according to any of the preceding claims, **characterised in that** a circuit stage which is common to magnetic field measurement, stress measurement and temperature measurement is provided with switches (2) for optional control of the three measurement options.

10. Hall sensor according to claim 9, **characterised in that** for signal processing, the signals are digitized by means of an analog-digital converter (ADC).

11. Hall sensor according to any of the preceding claims, **characterised by** a device to compensate for the Hall voltage and/or stress voltage and/or temperature voltage by means of a counter-coupling voltage.

12. Hall sensor according to claim 11, **characterised in that** the signals are digitized by means of a delta-sigma converter of the first or higher order.

13. Hall sensor according to claim 11 or 12, **characterised in that** a first amplifier (3) is provided which converts the Hall voltage into a current, in particular a differential current pair, **in that** in a subsequent stage comprising a second amplifier (4) with an integrator this current is integrated and processed further as a voltage signal, and **in that** a device is present which converts this voltage signal into a counter-coupling signal.

14. Hall sensor according to claim 13, **characterised in that** the analog voltage of the second amplifier (4) is digitized to form the counter-coupling signal.

## Revendications

1. Capteur à effet Hall
avec un dispositif pour la commutation orthogonale du courant d'alimentation du capteur à effet Hall ainsi que des prises de tension de Hall,
la géométrie de la plaque de Hall (1) étant identique dans les positions orthogonales pour la détermination de la tension de Hall,
ainsi qu'avec un dispositif additionneur auquel sont amenées les valeurs de tension de Hall des positions orthogonales pour la formation d'une valeur de tension de Hall compensée en décalage,
**caractérisé en ce**
**que**, pour une mesure de contrainte, les valeurs de tension de Hall des positions orthogonales sont amenées au dispositif additionneur et/ou traitées dans le dispositif additionneur de façon que les composantes des valeurs de tension de Hall dues au champ magnétique soient compensées et que seules les composantes des valeurs de tension de Hall dues au décalage soient mesurées
et/ou
**que** l'on utilise pour une mesure de température au moins un courant (I1, 12, 13) présent dans le circuit du capteur à effet Hall avec un coefficient de température donné, dont on utilise la chute de tension sur une résistance (R ; Rwell) pour la mesure de température.

2. Capteur à effet Hall selon la revendication 1,
**caractérisé en ce**
**que** lors de la commutation orthogonale, le courant d'alimentation du capteur à effet Hall est inversé de 180° par rapport à la commutation orthogonale pour la formation de la valeur de tension de Hall compensée en décalage pour la mesure de contrainte,
tandis que la commutation orthogonale des prises de tension de Hall est inchangée par rapport à la commutation orthogonale pour la formation de la valeur de tension de Hall compensée en décalage.

3. Capteur à effet Hall selon l'une des revendications précédentes,
**caractérisé en ce**
**que** l'on utilise un seul courant présent dans le circuit du capteur à effet Hall avec un coefficient de température donné.

4. Capteur à effet Hall selon l'une des revendications précédentes,
**caractérisé en ce**
**que** l'on additionne ou soustrait deux courants (11, 12) présents dans le circuit du capteur à effet Hall avec des coefficients de température différents l'un de l'autre.

5. Capteur à effet Hall selon la revendication 4,
**caractérisé en ce**
**qu'**un courant (I1) est connecté à un point de dérivation de courant et qu'un courant partiel (13) résultant est conduit à travers une résistance (R ; Rwell) et la chute de tension résultante est utilisée pour la suite du traitement des signaux.

6. Capteur à effet Hall selon la revendication 4,
**caractérisé en ce**
**que** le courant (I1) amené présente un premier coefficient de température et le courant partiel (13) résultant un deuxième coefficient de température.

7. Capteur à effet Hall selon l'une des revendications précédentes,
**caractérisé en ce**
**que** l'on utilise pour la formation d'au moins un courant (I1, I2, I3) un circuit à bande interdite avec des transistors bipolaires.

8. Capteur à effet Hall selon l'une des revendications précédentes,
**caractérisé en ce**
**que** l'on utilise la plaque de Hall (1) comme résistance (Rwell) pour la mesure de température.

9. Capteur à effet Hall selon l'une des revendications précédentes,
**caractérisé en ce**
**qu'**il est prévu un étage de commutation commun pour la mesure du champ magnétique, la mesure de contrainte et la mesure de température, avec des commutateurs (2) pour l'activation au choix des trois options de mesure.

10. Capteur à effet Hall selon la revendication 9,
**caractérisé en ce**
**que** pour leur traitement les signaux sont numérisés au moyen d'un convertisseur analogique-numérique (CAN).

11. Capteur à effet Hall selon l'une des revendications précédentes,
**caractérisé par**
un dispositif pour la compensation de la tension de Hall et/ou de la tension de contrainte et/ou de la tension de température au moyen d'une tension de contre-réaction.

12. Capteur à effet Hall selon la revendication 11,
**caractérisé en ce**
**que** la numérisation des signaux est réalisée au moyen d'un convertisseur delta-sigma d'ordre 1 ou supérieur.

13. Capteur à effet Hall selon la revendication 11 ou 12,
**caractérisé en ce**
**qu'**il est prévu un premier amplificateur (3) qui convertit la tension de Hall en un courant, en particulier en une paire de courants différentiels,
**que** ce courant est intégré et traité sous forme de signal de tension dans un étage placé à la suite qui contient un deuxième amplificateur (4) avec un intégrateur,
et **qu'**il est prévu un dispositif qui convertit ce signal de tension en un signal de contre-réaction.

14. Capteur à effet Hall selon la revendication 13,
**caractérisé en ce**
**que** la tension analogique du deuxième amplificateur (4) est numérisée pour former le signal de contre-réaction.
